# EUROPEAN PATENT SPECIFICATION

(11) **EP 1 592 289 B1**
(45) Date of publication and mention of the grant of the patent: **11.06.2008**
(21) Application number: 05009384.8
(22) Date of filing: 28.04.2005
(51) Int. Cl.: H05K 1/16, H05K 3/18

(54) **Method for fabricating embedded thin film resistors**
Verfahren zur Herstellung von eingebetteten Dünnschichtwiderständen
Procédé de fabrication de résistances encastrées à couche mince

(30) Priority: 30.04.2004 CN 200410037260
(43) Date of publication of application: 02.11.2005
(73) Proprietor: Brain Power Co., Taipei (TW)
(72) Inventor: Su, Sung-Ling, Taipei (TW); Xu, Zhiqiang, Taipei (TW)
(74) Representative: Viering, Jentschura & Partner

(56) References cited:
- EP-A- 0 163 760
- EP-A- 0 837 623
- US-A1- 2004 076 743

## Description

### FIELD OF THE INVENTION

The present invention generally relates to a printed circuit board according to the preamble of claim 1, and more specifically to a method for fabricating embedded thin film resistors of a printed circuit board.

### BACKGROUND OF THE INVENTION

A method for fabricating embedded thin film resistors of a printed circuit board of the initially-mentioned type is known, e.g., from EP-A-0 837 623.

In general, besides using conventional discrete passive elements, a printed circuit board can also use a thick film or a thin film process to develop the resistors required. In the thick film process, the resistors of the printed circuit board are made of carbon paste printed on the printed circuit board. Then the resistances of the resistors are fine-tuned by the laser trimming. In the thin film process, on the other hand, a nickel-plated copper foil and the epoxy resin of the printed circuit board is pressed together during the fabricating process of the printed circuit board. The nickel-plated side of the copper foil faces toward the printed circuit board and the non-plated side of the copper foil faces outward. Then, in a subsequent photolithography process, an acid etching solution is first used to etch both the copper and nickel layers, and then an alkaline etching solution is used to etch away the copper layer. A number of nickel blocks with the required dimensions are thereby formed. Laser is then used to trim each of the nickel blocks to achieve the precise resistance required.

In addition, currently, there is an electroless deposition technology that can replace the foregoing thin film method for building the resistor blocks to form thin film resistors.

In conventional thick film resistor fabricating methods, using high curing temperature carbon paste for the resistors is rather simple, mature, and less costly. However, because the laminate of the printed circuit board is susceptible to high temperature, low curing temperature carbon paste is usually used. The macromolecular polymer contained in the low curing temperature carbon paste will remain in the formed resistors even after the curing and solidification processes of the resistors. The hydrophilic property of the macromolecular polymer is the major factor causing the resistances of the resistors to vary along with the environmental change. Therefore, resistors having constant and precise resistances are difficult to achieve. On the other hand, the conventional thin film methods use the same temperatures and solutions as the conventional printed circuit board fabrication methods. The fabricated embedded resistors also have better stability and accuracy than those made by thick film methods. However, because the nickel-plated copper foil is difficult to manufacture, there are only limited supply sources and therefore the price is high. Although there are methods using the electroless deposition technology, the fabricated thin film resistors have inadequate adherence due to certain process factors. The application of these methods for mass production is thereby limited. Accordingly, the present invention is aimed at overcoming problems and disadvantages of conventional methods for fabricating thin film resistors of printed circuit boards.

### SUMMARY OF THE INVENTION

The method provided by the present invention can be applied to single-sided, double-sided, multi-layered, and build-up printed circuit boards. The present invention develops at least a resistor layer in at least any one layer of the printed circuit board. The resistor layer is then etched to form a number of resistor elements required by the circuit layout of the printed circuit board.

The embedded thin film resistors made by the present invention replace the bulky conventional discrete resistors. The printed circuit board can therefore have finer circuit layout and much smaller size. The capacitive reactance effect usually found at the connectors of conventional discrete resistors is also avoided. The signal transmission speed and quality of the printed circuit board is therefore significantly enhanced, especially for high frequency applications. The process for forming the resistor layer provided by the present invention is very similar to that used for ordinary printed circuit boards and can be carried out using the same equipment. Therefore there is no significant investment on new equipment. The process for forming the resistor layer provided by the present invention, just like the process for ordinary printed circuit boards, is applicable in mass production and contributes to a significant lower manufacturing cost.

The foregoing and other objects, features, aspects and advantages of the present invention will become better understood from a careful reading of a detailed description provided herein below with appropriate reference to the accompanying drawings.

### BRIEF DESCRIPTION OF THE DRAWINGS

Figure 1 is a flow chart showing the steps of forming embedded thin film resistors on a printed circuit board according to a first embodiment of the present invention.

Figures 2(a)-2(f) are schematic diagrams showing the various steps of Figure 1 respectively.

Figure 3 is a flow chart showing the steps of forming embedded thin film resistors on a printed circuit board according to a second embodiment of the present invention.

Figures 4(a)-4(i) are schematic diagrams showing the various steps of Figure 3 respectively.

Figures 5(a)-5(e) are schematic diagrams showing the various steps of depositing multiple resistor layers respectively according to the present invention.

### DETAILED DESCRIPTION OF THE PREFERRED EMBODIMENTS

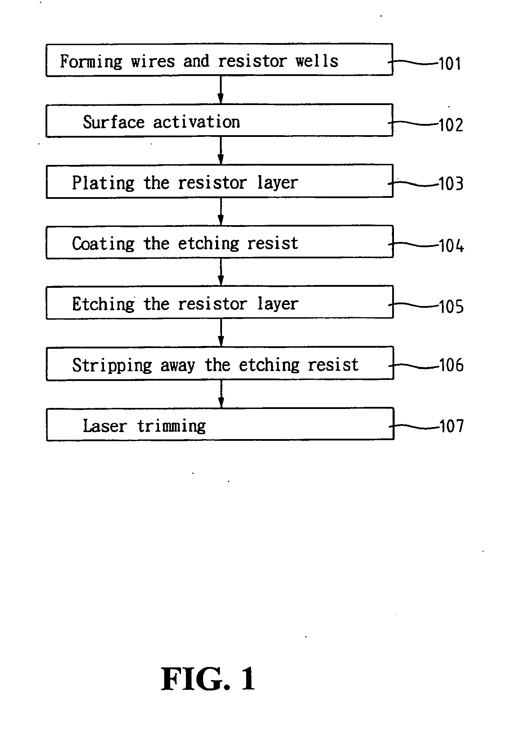

Figure 1 is a flow chart showing the steps of forming embedded thin film resistors on a printed circuit board according to a first embodiment of the present invention. These steps are described sequentially as follows.

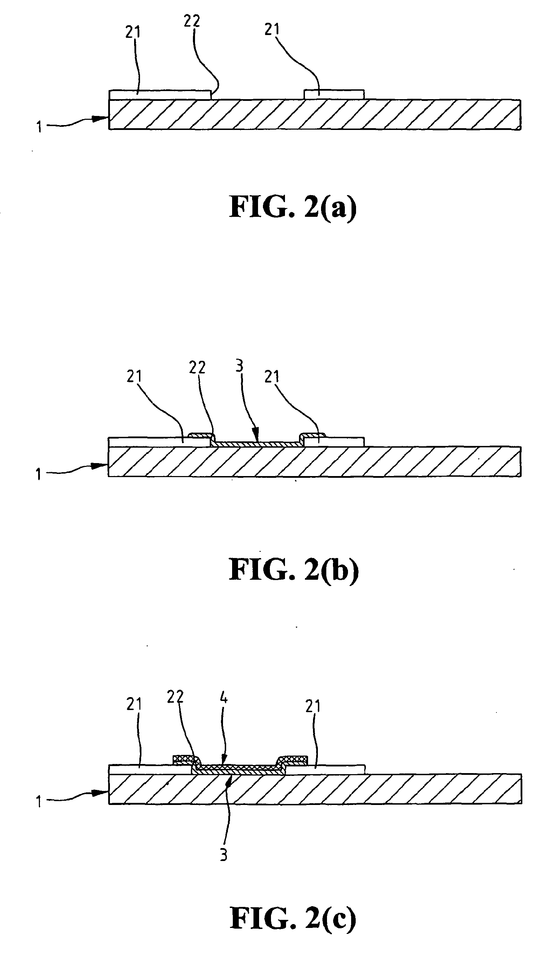

In step 101, as shown in Figure 2(a), the conductive wires 21 with resistor wells 22 are formed on a substrate made of an insulating polymer according to layout requirement of circuitry.

The foregoing conductive wires 21 and resistor wells 22 can be formed using an ordinary printed circuit board fabrication process such as the subtractive, additive, or semi-additive process. The conductive wire 21 is made of copper, aluminum, other well conductive material, or an alloy of the above.

In step 102, as shown in Figure 2(b), an activated layer 3 is coated on top of at least surface of each resistor well 22 so as to activate the insulating polymer of the substrate 1 exposed by each resistor well 22.

The foregoing activated layer 3 is made of activated palladium (Pd) or other appropriate activator that can be used to form the activated layer using a printing, spraying, or dipping method.

In step 103, as shown in Figure 2(c), the printed circuit board is immersed in an electroless nickel solution so that a resistor layer 4 with an expected thickness is plated on the activated layer 3.

The foregoing resistor layer 4 can be made of a nickel-phosphorus.

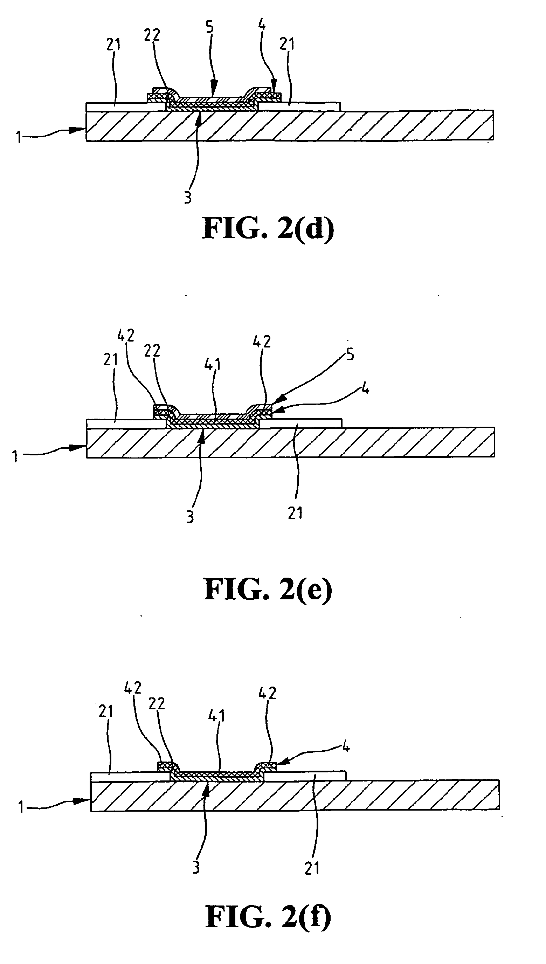

In step 104, as shown in Figure 2(d), an etching resist 5 is coated on the resistor layer 4, based on the locations and dimensions of the resistors required by the printed circuit board.

The foregoing etching resist 5 is made of etching resistible dry film, wet film, ink, plastic film, or solder mask ink, and can be formed by a screen printing or photolithography process.

In step 105, as shown in Figure 2(e), the resistor layer 4 is etched to form a number of resistor elements 41 and contact points 42 matching the locations and dimensions of the etching resist 5. On two ends of each of the resistor elements 41, contact points 42 are formed so that each resistor element 41 is connected to the conductive wires 21.

In step 106, as shown in Figure 2(f), the etching resist 5 on the resistor layer 4 is stripped away.

The foregoing etching resist 5 on the resistor layer 4 may not be stripped away if the etching resist 5 is made of solder mask ink.

In step 107, the shape and dimension of each resistor element 41 of the resistor layer 4 is adjusted to obtain accurate resistance by laser trimming.

At the end of this step, each resistor element 41 of the resistor layer 4 can be coated with protective ink. The protective ink is then heated and solidified so that subsequent processes of the printed circuit board do not affect the resistance of each resistor element 41. The coating and solidification of the protective ink can also be conducted before the laser trimming. In this way, undesirable influence of the ink coating and solidification on the resistances of the resistor elements 41 can be avoided after their resistances are adjusted by laser trimming.

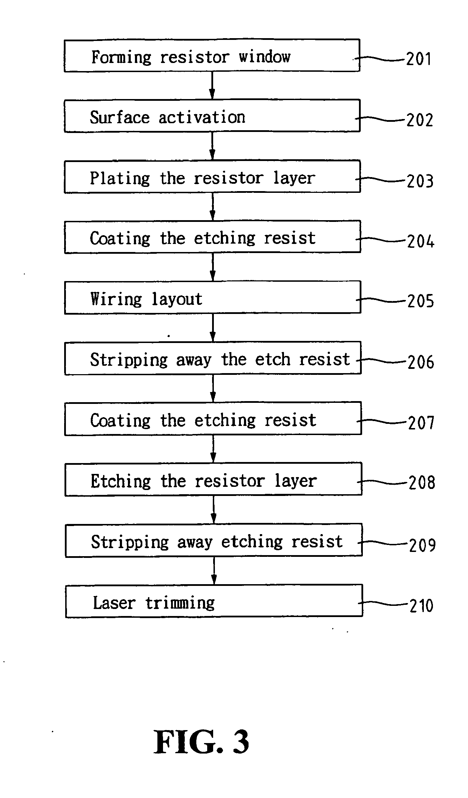

Figure 3 is a flow chart showing the steps of forming embedded thin film resistors on a printed circuit board according to a second embodiment of the present invention. These steps are described sequentially as follows.

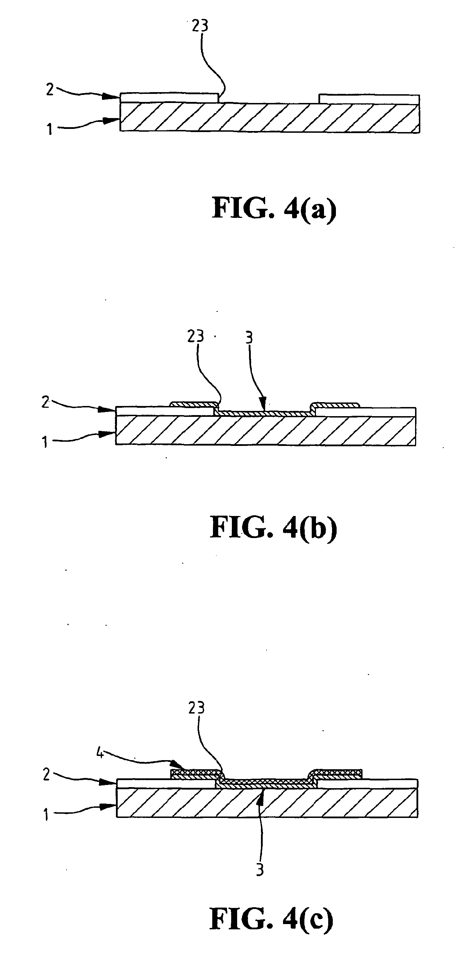

In step 201, as shown in Figure 4(a), a conductive layer 2 is formed on a substrate 1 made of an insulating polymer. The conductive layer 2 is then processed, based on the locations and dimensions of the resistors required by the printed circuit board, to form the corresponding resistor windows 23.

The conductive layer 2 is made of copper, aluminum, other well conductive material, or an alloy of the above.

In step 202, as shown in Figure 4(b), an activated layer 3 is coated on top of at least surface of each resistor window 23 of the conductive layer 2 so as to activate the insulating polymer of the substrate 1 exposed by each resistor window 23.

The foregoing activated layer 3 is made of activated palladium (Pd) or other appropriate activator that can be used to form the activated layer 3 using a printing, spraying, or dipping method.

In step 203, as shown in Figure 4(c), the printed circuit board is immersed in an electroless nickel solution so that a resistor layer 4 with an expected thickness is coated on the activated layer 3.

The foregoing resistor layer 4 can be made of a nickel-phosphorus.

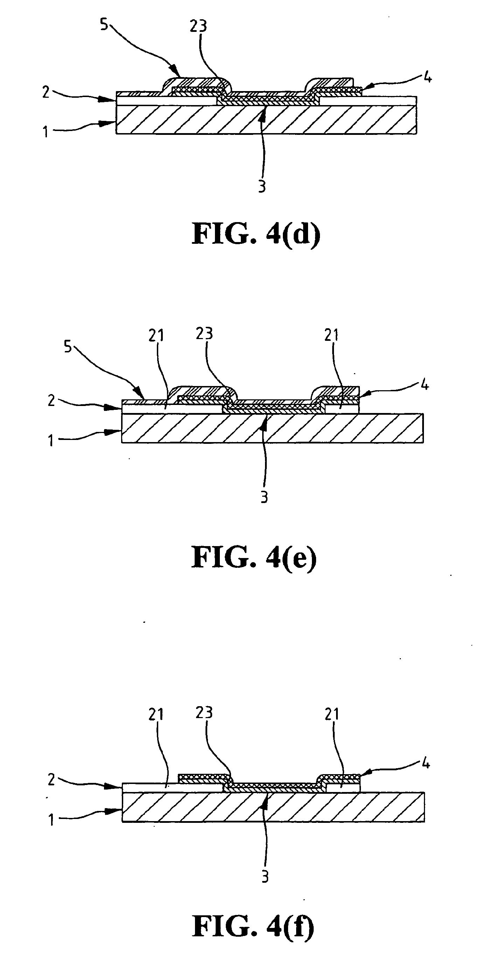

In step 204, as shown in Figure 4(d), an etching resist 5 is coated on the resistor layer 4, based on the locations and dimensions of the layout of the conductive wires and the resistor windows required by the printed circuit board.

The foregoing etching resist 5 is made of etching resistible dry film, wet film, ink, plastic film, or solder mask ink, and can be formed by a screen printing or photolithography process.

In step 205, as shown in Figure 4(e), the resistor layer 4 and conductive layer 2 are etched together according to the locations and dimensions of the etching resist 5 so that the layout of conductive wires 21 of the conductive layer 2 and the resistor windows required by the printed circuit board are formed.

In step 206, as shown in Figure 4(f), the etching resist 5 on the resistor layer 4 is stripped away.

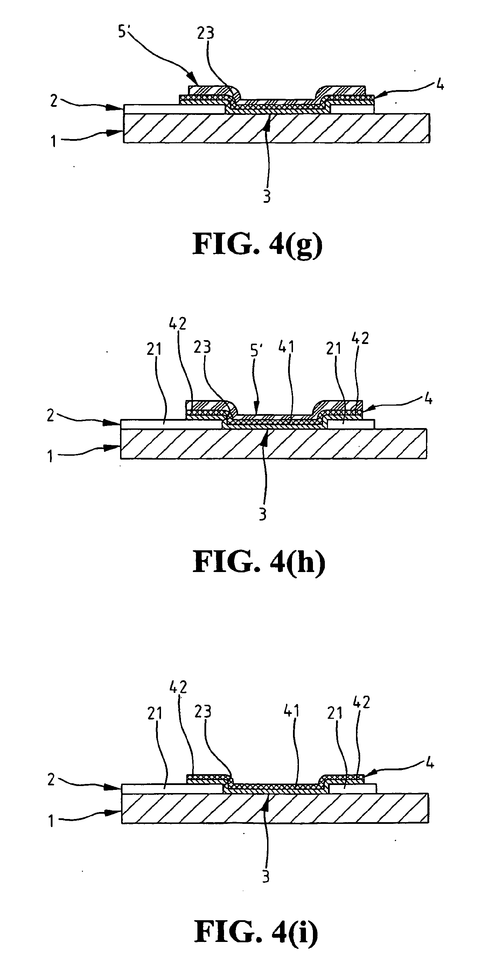

In step 207, as shown in Figure 4(g), an etching resistible etching resist 5' is coated on the resistor layer 4, based on the locations and dimensions of the resistors required by the printed circuit board.

In step 208, as shown in Figure 4(h), the resistor layer 4 is etched to form a number of resistor elements 41 matching the locations and dimensions of the etching resist 5'. On two ends of the resistor elements 41, contact points 42 are formed to connect with the conductive wires 21 of the conductive layer 2.

In step 209, as shown in Figure 4(i), the etching resist 5' on the resistor layer 4 is stripped away.

The foregoing etching resist 5' on the resistor layer 4 may not be stripped away if the etching resist 5' is made of solder mask ink.

In step 210, the shape and dimension of each resistor element 41 of the resistor layer 4 is adjusted to obtain accurate resistance by laser trimming.

In the foregoing steps 205 to 209, the layout of conductive wires 21 is first formed by etching the conductive layer 2 and the resistor elements 41 is then formed by etching the resistor layer 4. If higher degree of accuracy is required, the etching of the conductive layer 2 and resistor layer 4 can be conducted together so that the layout of conductive wires 21 and each of the resistor elements 41 are formed according to the locations and dimensions of the etching resist 5. The etching resist 5 is then stripped away. Subsequently, the conductive layer 2 and resistor layer 4 is coated with another etching resist 5' according to the locations and dimensions of the resistors required by the printed circuit board. Then the superfluous resistor layer 4 on the conductive layer 2 is etched away. Each individual resistor elements 41 has two contact points 42 connecting with the conductive wires 21 of the conductive layer 2. The etching resist 5' is then stripped away.

At the end of the foregoing process, each resistor element 41 of the resistor layer 4 can be coated with protective ink. The protective ink is then heated and solidified so that subsequent processes of the printed circuit board do not affect the resistance of each resistor element 41. The coating and solidification of the protective ink can also be conducted before the laser trimming. In this way, undesirable influence of the ink coating and solidification on the resistances of the resistor elements 41 can be avoided after their resistances are adjusted by laser trimming.

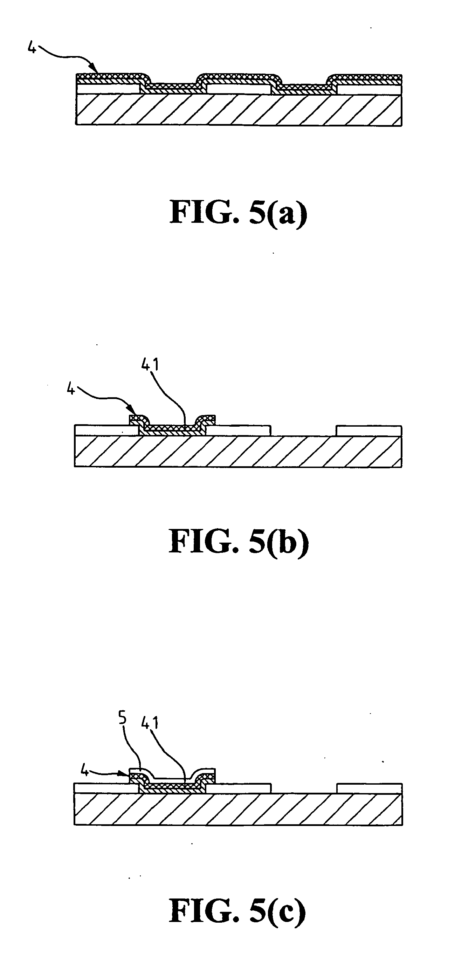

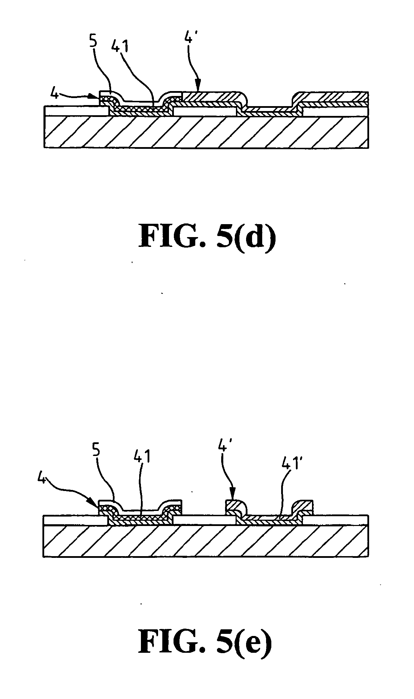

The resistance of the resistor element 41 depends on the thickness and dimension of the resistor element 41, and the volume resistivity of the material used for the resistor layer 4. Since the thickness and volume resistivity of the resistor elements 41 are the same because they are all developed from the same deposition of resistor layer 4, adjusting the dimension of the resistor elements 41 is the only way to differentiate the resistance among the resistor elements 41. For resistor elements 41 having a large resistance, their shape would be much longer or narrower than those having a smaller resistance. Therefore there is a range limitation on the resistance achievable by varying the dimension of the resistor elements 41. To overcome these disadvantages, multiple resistor layers 4 can be deposited. As shown in Figure 5(a), to form a number of resistor elements 41 having similar resistance, a resistor layer 4 having a specific volume resistivity and thickness is deposited first. Then the foregoing process is applied to form the required resistor elements 41 as shown in Figure 5(b). The resistor elements 41 all have identical thickness and volume resistivity. Their resistances are then fine-tuned by adjusting their dimensions. Then, as shown in Figure 5(c), a protective film is coated to protect the resistor elements 41 in subsequent operations. Then, for another set of required resistor elements 41', another resistor layer 4' having a specific volume resistivity and thickness is deposited as shown in Figure 5(d). The same process is repeated to form the required resistor elements 41' as shown in Figure 5(e). The resistor elements 41' all have identical thickness and volume resistivity. Their resistances are then fine-tuned by adjusting their dimensions. Similarly additional resistor layers can be deposited so that resistor elements can have a large variance in their resistances. The process can be conducted on the same layer or on different layers of a printed circuit board if the printed circuit board has more than one layer.

The resistor elements 41 and 41' of the resistor layer 4 and 4' respectively can have their dimensions etched or laser-trimmed simultaneously at the end so as to achieve the desired resistances.

In addition, the method provided by the present invention can be applied to single-sided, double-sided, multi-layered, and build-up printed circuit boards. In these printed circuit boards, at least a resistor layer 4 is formed in at least any one layer of these printed circuit boards and etched to obtain the resistor elements 41 required by the circuit layout of the printed circuit boards. Electrical connections are then established between the resistor elements 41 and the conductive wires 21.

Although the present invention has been described with reference to the preferred embodiments, it will be understood that the invention is not limited to the details described thereof. Various substitutions and modifications have been suggested in the foregoing description, and others will occur to those of ordinary skill in the art. Therefore, all such substitutions and modifications are intended to be embraced within the scope of the invention as defined in the appended claims.

## Claims

1. Method for fabricating embedded thin film resistors of a printed circuit board comprising the steps of:
(a) forming conductive wires (21) with resistor wells (22) according to layout requirement of circuitry on a substrate (1) made of an insulating polymer by a method selected from the group consisting of subtractive, additive, and semi-additive;
(b) coating an activated layer (3) on each of said resistor wells (22) respectively so as to activate said substrate's (1) insulating polymer exposed by said resistor wells (22);
(c) immersing said printed circuit board in a electroless nickel solution so that a resistor layer (4) having a first volume resistivity is plated on said activated layer (3) until said resistor layer (4) is deposited to a first thickness;
**characterized in that** the method further comprises the steps of:
(d) coating an etching resist (5) on said resistor layer (4) based on locations and dimensions of resistors required by said printed circuit board; and
(e) etching said resistor layer (4) to form a plurality of resistor elements (41) matching said locations and dimensions of said etching resist, wherein each of said resistor elements (41) has two contact points (42) connecting with said conductive wires (21).

2. Method for fabricating embedded thin film resistors of a printed circuit board according to Claim 1, wherein said activated layer (3) is made of an activator that can be formed into said activated layer (3) by a method selected from the group consisting of printing, spraying, and dipping.

3. Method for fabricating embedded thin film resistors of a printed circuit board according to Claim 1, wherein said resistor layer (4) is made of a metallic material consisting of nickel-phosphorus.

4. Method for fabricating embedded thin film resistors of a printed circuit board according to Claim 1, wherein said etching resist (5) is formed by a method selected from a group consisting of screen printing and photolithography.

5. Method for fabricating embedded thin film resistors of a printed circuit board according to Claim 1, wherein said etching resist (5) is made of an etching resistible material selected from the group consisting of dry film, wet film, ink, plastic film, and solder mask ink.

6. Method for fabricating embedded thin film resistors of a printed circuit board according to Claim 1, wherein shapes and dimensions of said resistor elements (41) are adjusted using a laser trimming process after said resistor elements (41) are formed to achieve accurate resistances.

7. Method for fabricating embedded thin film resistors of a printed circuit board according to Claim 6, wherein a protective ink is coated on each of said resistor elements (41) after said resistor elements (41) are formed and said protected ink is heated and solidified after said laser trimming process is applied.

8. Method for fabricating embedded thin film resistors of a printed circuit board according to Claim 6, wherein a protective ink is coated on each of said resistor elements (41) after said resistor elements (41) are formed and said protected ink is heated and solidified before said laser trimming process is applied.

9. Method for fabricating embedded thin film resistors of a printed circuit board according to Claim 1, wherein said steps (c), (d), and (e) are repeated to develop another resistor layer (4) having a second volume resistivity and a second thickness and to form another plurality of resistor elements (41) required by said printed circuit board.

10. Method for fabricating embedded thin film resistors of a printed circuit board according to Claim 9, wherein said resistor elements (41) have shapes and dimensions adjusted together after said resistor elements (41) are developed from said resistor layer (4)s using a process selected from the group consisting of etching and laser trimming.

11. Method for fabricating embedded thin film resistors of a printed circuit board according to Claim 9, wherein said steps (c), (d), and (e) are repeated a plurality of times to develop multiple resistor layer (4)s having specific volume resistivity and thickness, and to form resistor elements (41) required by said printed circuit.

12. Method for fabricating embedded thin film resistors of a printed circuit board according to Claim 1, further comprising the steps of:
(f) stripping said first etching resist (5) on top of said resistor layer (4);
(g) coating a second etching resist (5) on said resistor layer (4) based on locations and dimensions of resistors required by said printed circuit board; and
(h) etching said resistor layer (4) to form a plurality of resistor elements (41) matching said locations and dimensions of said second etching resist, wherein each of said resistor elements (41) has two contact points (42) connecting with said conductive wires (21).

## Patentansprüche

1. Verfahren zur Herstellung von eingebetteten Dünnschichtwiderständen einer Leiterplatte, aufweisend die Schritte:
(a) Bilden von leitfähigen Verbindungen (21) mit Widerstandswannen (22) entsprechend der Layoutanforderung des Schaltkreises auf einem Substrat (1) aus einem isolierenden Polymer durch ein Verfahren ausgewählt aus der Gruppe, bestehend aus Subtraktiv, Additiv und Halbadditiv;
(b) Überziehen einer aktivierten Schicht (3) auf jede Widerstandwanne (22) jeweils derart, dass damit das isolierende Polymer des Substrates (1), freigelegt durch die Widerstandswannen (22), aktiviert wird.
(c) Eintauchen der Leiterplatte in eine stromlose Nickellösung, so dass eine Widerstandsschicht (4), die einen ersten Volumenwiderstand hat, auf der aktivierten Schicht (3) beschichtet wird, bis die Widerstandsschicht (4) bis zu einer ersten Dicke aufgetragen ist;
**dadurch gekennzeichnet, dass** das Verfahren weiterhin die Schritte aufweist:
(d) Überziehen eines Ätzresists (5) auf die Widerstandsschicht (4), basierend auf Positionen und Größen von Widerständen, die bei der Leiterplatte benötigt werden; und
(e) Ätzen der Widerstandsschicht (4), so dass eine Mehrzahl von Widerstandselementen (41) gebildet wird, die den Positionen und Größen des Ätzresists entsprechen, wobei jedes Widerstandselement (41) zwei Kontaktstellen (42) hat, die mit den leitenden Verbindungen (21) verbunden sind.

2. Verfahren zur Herstellung von eingebetteten Dünnschichtwiderständen einer Leiterplatte, gemäß Anspruch 1, wobei die aktivierte Schicht (3) von einem Aktivator gebildet wird, der in der aktivierten Schicht (3) gebildet werden kann mit einem Verfahren, ausgewählt aus der Gruppe, bestehend aus Drucken, Spritzen und Tauchen.

3. Verfahren zur Herstellung von eingebetteten Dünnschichtwiderständen einer Leiterplatte, gemäß Anspruch 1, wobei die Widerstandsschicht (4) aus einem metallischen Material bestehend aus Nickel-Phosphor hergestellt wird.

4. Verfahren zur Herstellung von eingebetteten Dünnschichtwiderständen einer Leiterplatte, gemäß Anspruch 1, wobei der Ätzresist (5) durch ein Verfahren hergestellt wird, ausgewählt aus einer Gruppe, bestehend aus Siebdruck und Photolihtographie.

5. Verfahren zur Herstellung von eingebetteten Dünnschichtwiderständen einer Leiterplatte, gemäß Anspruch 1, wobei der Ätzresist (5) aus einem ätzresistenen Material hergestellt wird, ausgewählt aus der Gruppe, bestehend aus Trockenfilm, Nassfilm, Tinte, Plastikfilm und Lötmaskentinte.

6. Verfahren zur Herstellung von eingebetteten Dünnschichtwiderständen einer Leiterplatte, gemäß Anspruch 1, wobei Formen und Größen der Widerstandselemente (41) mit einem Lasertrimprozess angepasst werden, nachdem die Widerstandselemente (41) gebildet wurden, um akkurate Widerstände zu erzielen.

7. Verfahren zur Herstellung von eingebetteten Dünnschichtwiderständen einer Leiterplatte, gemäß Anspruch 6, wobei eine Schutztinte auf jede Seite der Widerstandselemente (41) überzogen wird, nachdem die Widerstandselemente (41) gebildet worden sind, und die Schutztinte aufgeheizt und gefestigt wird, nachdem der Lasertrimmprozess angewendet worden ist.

8. Verfahren zur Herstellung von eingebetteten Dünnschichtwiderständen einer Leiterplatte, gemäß Anspruch 6, wobei eine Schutztinte auf jede Seite der Widerstandselemente (41) überzogen wird, nachdem die Widerstandselemente (41) gebildet worden sind, und die Schutztinte aufgeheizt und gefestigt wird, bevor der Lasertrimmprozess angewandt wird.

9. Verfahren zur Herstellung von eingebetteten Dünnschichtwiderständen einer Leiterplatte, gemäß Anspruch 1, wobei die Schritte (c), (d) und (e) wiederholt werden, um eine andere Widerstandsschicht mit einem zweiten Volumenwiderstand und einer zweiten Dicke zu entwickeln und eine andere Mehrzahl von Widerstandselementen (41) zu formen, die die Leiterplatte benötigt.

10. Verfahren zur Herstellung von eingebetteten Dünnschichtwiderständen einer Leiterplatte, gemäß Anspruch 9, wobei die Widerstandselemente (41) Formen und Größen haben, die gemeinsam angepasst werden, nachdem die Widerstandselemente (41) aus der Widerstandsschicht (4) entwickelt wurden unter Verwendung eines Prozesses, ausgewählt aus einer Gruppe, bestehend aus Ätzen und Lasertrimmen.

11. Verfahren zur Herstellung von eingebetteten Dünnschichtwiderständen einer Leiterplatte, gemäß Anspruch 9, wobei die Schritte (c), (d), und (e) mehrmals wiederholt werden, um mehrere Widerstandsschichten (4) mit spezifischem Volumenwiderstand und Dicke zu entwickeln, und um Widerstandselemente (41) zu bilden, die bei der Leiterplatte benötigt werden.

12. Verfahren zur Herstellung von eingebetteten Dünnschichtwiderständen einer Leiterplatte, gemäß Anspruch 1, weiterhin die Schritte aufweisend:
(f) Strippen des ersten Ätzresists (5) auf der Widerstandsschicht (4);
(g) Überziehen der Widerstandsschicht (4) mit einem zweiten Ätzresist (5), basierend auf Positionen und Größen der Widerstände, wie sie bei der Leiterplatte benötigt werden; und
(h) Ätzen der Widerstandsschicht (4), so dass eine Mehrzahl von Widerstandselementen (41), die in Position und Größe des zweiten Ätzresists angepasst sind, zu bilden, wobei jedes der Widerstandselemente (41) zwei Kontaktstellen (42) hat, die mit den leitenden Verbindungen (21) verbunden sind.

## Revendications

1. Procédé de fabrication de résistances encastrées à couche mince d'une carte à circuit imprimé, comprenant les étapes consistant à :
(a) former des fils conducteurs (21) avec des puits de résistance (22) selon une exigence de schéma d'implantation de la circuiterie sur un substrat (1) formé d'un polymère isolant par un procédé sélectionné dans le groupe composé des procédés soustractifs, additifs, et semi-additifs ;
(b) appliquer en revêtement une couche (3) activée, sur chacun desdits puits de résistance (22), respectivement, afin d'activer ledit polymère isolant de substrat (1) exposé par lesdits puits de résistance (22) ;
(c) immerger ladite carte à circuit imprimé dans une solution de dépôt chimique auto-catalytique de nickel, de manière qu'une couche de résistance (4) ayant une première résistivité volumique soit appliquée en placage sur ladite couche (3) activée, jusqu'à ce que ladite couche de résistance (4) soit déposée à une première épaisseur,
**caractérisé en ce que** le procédé comprend en outre les étapes consistant à :
(d) appliquer en revêtement une réserve de gravure (5) sur ladite couche de résistance (4) d'après les emplacements et les dimensions des résistances nécessités par ladite carte à circuit imprimé ; et
(e) graver ladite couche de résistance (4) pour former une pluralité d'éléments de résistance (41) coïncidant avec lesdits emplacements et dimensions de ladite réserve de gravure, dans lequel chacun desdits éléments de résistance (41) comprend deux points de contact (42) se connectant auxdits fils conducteurs (21).

2. Procédé de fabrication de résistances encastrées à couche mince d'une carte à circuit imprimé selon la revendication 1, dans lequel ladite couche (3) activée est formée d'un activateur pouvant être formé dans ladite couche (3) activée, par un procédé sélectionné dans le groupe composé de l'impression, la pulvérisation et l'immersion.

3. Procédé de fabrication de résistances encastrées à couche mince d'une carte à circuit imprimé selon la revendication 1, dans lequel ladite couche de résistance (4) est formée d'un matériau métallique composé de nickel-phosphore.

4. Procédé de fabrication de résistances encastrées à couche mince d'une carte à circuit imprimé selon la revendication 1, dans lequel ladite réserve de gravure (5) est formée par un procédé sélectionné dans un groupe composé de l'impression sérigraphique et de la photolithographie.

5. Procédé de fabrication de résistances encastrées à couche mince d'une carte à circuit imprimé selon la revendication 1, dans lequel ladite réserve de gravure (5) est formée d'un matériau susceptible de résister à la gravure, sélectionné dans le groupe composé d'un film sec, d'un film humide, d'encre, de film de matière synthétique et d'encre de masquage pour brasure.

6. Procédé de fabrication de résistances encastrées à couche mince d'une carte à circuit imprimé selon la revendication 1, dans lequel les formes et les dimensions desdits éléments de résistance (41) sont ajustées en utilisant un procédé de découpage au laser, après que lesdits éléments de résistance (41) aient été formés pour obtenir des résistances précises.

7. Procédé de fabrication de résistances encastrées à couche mince d'une carte à circuit imprimé selon la revendication 6, dans lequel une encre protectrice est appliquée en revêtement sur chacun desdits éléments de résistance (41) après que lesdits éléments de résistance (41) aient été formés, et ladite encre protectrice est chauffée et solidifiée après que ledit procédé de découpage au laser soit appliqué.

8. Procédé de fabrication de résistances encastrées à couche mince d'une carte à circuit imprimé selon la revendication 6, dans lequel une encre protectrice est appliquée en revêtement sur chacun desdits éléments de résistance (41), après que lesdits éléments de résistance (41) aient été formés, et ladite encre protectrice est chauffée et solidifiée avant que ledit procédé de découpage au laser soit appliqué.

9. Procédé de fabrication de résistances encastrées à couche mince d'une carte à circuit imprimé selon la revendication 1, dans lequel lesdites étapes (c), (d) et (e) sont répétées pour développer une autre couche de résistance (4) ayant une deuxième résistivité volumique et une deuxième épaisseur et pour former une autre pluralité d'éléments de résistance (41) rendus nécessaires pour ladite carte à circuit imprimé.

10. Procédé de fabrication de résistances encastrées à couche mince d'une carte à circuit imprimé selon la revendication 9, dans lequel lesdits éléments de résistance (41) ont des formes et des dimensions ajustées ensemble, après que lesdits éléments de résistance (41) aient été développés à partir de ladite couche de résistance (4), en utilisant un procédé sélectionné dans le groupe composé de la gravure et du découpage au laser.

11. Procédé de fabrication de résistances encastrées à couche mince d'une carte à circuit imprimé selon la revendication 9, dans lequel lesdites étapes (c), (d) et (e) sont répétées une pluralité de fois afin de développer une pluralité de couches de résistance (4) ayant une résistivité volumique et une épaisseur spécifique et pour former des éléments de résistance (41) nécessaires audit circuit imprimé.

12. Procédé de fabrication de résistances encastrées à couche mince d'une carte à circuit imprimé selon la revendication 1, comprenant en outre les étapes consistant à :
(f) enlever par pelage ladite première réserve de gravure (5) en partie supérieure de ladite couche de résistance (4) ;
(g) appliquer en revêtement une deuxième réserve de gravure (5) sur ladite couche de résistance (4), d'après les emplacements et les dimensions des résistances nécessaires à ladite carte à circuit imprimée ; et
(h) graver ladite couche de résistance (4) pour former une pluralité d'éléments de résistance (41) coïncidant avec lesdits emplacements et dimensions de ladite deuxième réserve de gravure, dans lequel chacun desdits éléments de résistance (41) comprend deux points de contact (42) se connectant auxdits fils conducteurs (21).
